(19) **Europäisches Patentamt**
**European Patent Office**
**Office européen des brevets**

(11) Veröffentlichungsnummer: **0 002 712**
**B1**

(12) EUROPÄISCHE PATENTSCHRIFT

(45) Veröffentlichungstag der Patentschrift: **15.09.82**

(51) Int. Cl.³: **C 23 C 15/00**

(21) Anmeldenummer: **78101634.0**

(22) Anmeldetag: **09.12.78**

(54) **Metallglasfilm.**

(30) Priorität: **30.12.77 US 866115**

(43) Veröffentlichungstag der Anmeldung:
**11.07.79 Patentblatt 79/14**

(45) Bekanntmachung des Hinweises auf die Patenterteilung:
**15.09.82 Patentblatt 82/37**

(84) Benannte Vertragsstaaten:
**DE FR GB**

(56) Entgegenhaltungen:
**DE - A - 1 483 246**
**FR - A - 1 299 153**
**US - A - 3 124 490**
**US - A - 3 414 430**
**US - A - 3 965 463**
**CHEMICAL ABSTRACTS, Vol. 83, Nr. 4, Juli 1975, Ref. Nr. 36851f, Columbus, Ohio, USA, YUHARA AKITSUNA et al.: "Permalloy magnetoresistance devices having amorphous iron or nickel nitride coating", Seite 598, linke spalte**
**IEEE TRANSACTIONS ON MAGNETICS, März 1976, Vol. MAG 12, Nr. 2, J. G. WRIGHT: "Amorphous transition metal films", Seiten 95—102**

(73) Patentinhaber: **International Business Machines Corporation**
**Armonk, N.Y. 10504 (US)**

(72) Erfinder: **Cuomo, Jerome John**
**P.O. Box 353**
**Lincolndale N.Y. 10540 (US)**
Erfinder: **Gangulee, Amitava**
**20 Mount Green Road**
**Croton-on-Hudson N.Y. 10520 (US)**
Erfinder: **Kobliska, Robert John**
**69 Beverley Road**
**Mount Kisco N.Y. 10549 (US)**

(74) Vertreter: **Busch, Robert, Dipl.-Ing.**
**Schönaicher Strasse 220**
**D-7030 Böblingen (DE)**

(56) Entgegenhaltungen:
**JOURNAL OF APPLIED PHYSICS, 1972, März 1972, Vol. 43, Nr. 3, H. F. WINTERS: "Influence of surface absorption characteristics on reactively sputtered film grown in the biased and unbiased modes", Seiten 794—799**
**Transaction of the Metallurgical Society of CIM 1977 Seite 133**

# 0 002 712

## Metallglasfilm

Die Erfindung betrifft einen Stickstoff enthaltenden Film aus Metallglas, ausschließlich bestehend sowohl aus mindestens einem der Übergangsmetalle Cr, Fe, Co, Ni als auch mindestens einem der Metalloide B, Si, C, P oder dem Metall Al als jeweilige Bestandteile einer binären oder ternären eutektischen Legierung.

In der US-Patentschrift 4 002 546 wird ein Ionenplattierverfahren beschrieben, bei dem die aus Co-Si, Co-Ni-Si, Co-Fe-Si oder Co-Ni-Fe-Si bestehenden magnetischen Werkstoffe auf ein Substrat aus Kunststoffglas oder nichtmagnetischem Material aufgebracht werden. Die Ionenplattierung soll zwar dabei in einer Glimmentladung unter Verwenden eines trägen Gases wie Stickstoff, Helium, Neon, Argon, Krypton, Xenon, Radon oder einer der Mischungen hiervon erfolgen, jedoch werden gemäß der in dieser Patentschrift gezeigten Beispiele nur Helium und Argon, aber nicht Stickstoff gebraucht. Mit Hilfe derart durchgeführter Ionenplattierung ergeben sich Aufzeichnungsträger mit magnetischen Filmen, bei denen neben ausgezeichneten magnetischen Eigenschaften jeweils gute Adhäsion zum Substrat vorliegt. Es findet sich weiterhin jedoch weder ein Hinweis auf die Bildung einer Filmzusammensetzung unter Einschluß eines der trägen Gase, schon gar nicht von Stickstoff, noch auf irgendeine spezielle Auswirkung, die durch Gasbeimischung in einem derartigen Metallglasfilm herbeigeführt werden könnte. Andererseits ist in der obengenannten Patentschrift keine Andeutung zu finden, daß sich die hier gezeigten Ergebnisse auf die tatsächliche Verwendung oder Beimischung von Stickstoff in Glasmetallen stützen. Demzufolge ist auch keinerlei einstellbar Wirkung auf spezifischen Widerstand, Magnetisierung $(4\pi M_s)$, effektives Anisotropiefeld $(H^*_k)$ oder Anisotropieenergie $K_u$, Korrosionsbeständigkeit, magnetothermische Stabilität oder mechanische Härte gezeigt. Wenn auch im Beispiel I unter Zerstäubung in Heliumatmosphäre Spuren von O, Ar, N und C festgestellt sind, so ist dies jedoch nicht weiter von Belang.

Die US-Patentschrift 3 856 513 bedient sich zur Herstellung einer amorphen Co-Fe-P-Legierung des Ausstoßens eines Schmelzflusses auf Walzen oder des Verdampfens einer $Ni_{75}P_{16}B_6S_3$-Legierung auf ein Kupfersubstrat. Stickstoff wird hierzu nicht verwendet.

In der Veröffentlichung "New Non-Magnetostrictive Metallic Glasses" in der Zeitschrift "IEEE Transactions on Magnetics", Vol. MAG-12, Nr. 6, Seiten 942—944 (November 1976) ist ein metallischer Glaslegierungsblock, bestehend aus $Co_{74}Fe_6B_{20}$, beschrieben, der eine hohe Sättigungsmagnetisierung $(4\pi M_s)$ mit $11,8 \cdot 10^{-5}$ Vs/cm² aufweist und eine geringe Feldstärke mit Hc von 2,79 A/m besitzt.

Die USA-Patentschrift 3 965 463 beschreibt zur Herstellung amorpher Schichten das Aufstäuben magnetischer Materialien, wie Gd-Fe und Gd-Co, in Argonatmosphäre unter Beteiligung kleiner Anteile von Stickstoff, und zwar in de Größenordnung von 1 Vol.-%, als Möglichkeit die Magnetisierung $4\pi M_s$ zu erhöhen oder zu verringern, indem die Austauschwechselwirkung zwischen den Bestandteilen der Mischung auf höhere oder geringere Magnetisierung abgeändert wird, je nachdem, welche Lage auf der Magnetisierungskurve, die in Abhängigkeit von der Zusammensetzung aufgetragen ist, eingestellt werden soll. Hier wird außerdem vorgeschlagen, die Koerzitivkraft $H_c$ durch Zufügen von Anteilen $O_2$ oder $N_2$ als Dotierung abzuändern, um die Korngröße einzustellen, obgleich amorphe Materialien im allgemeinen keine Körnigkeit besitzen, jedoch im Hinblick darauf, daß die Koerzitivkraft von den Korngröße abhängig ist. Es findet sich jedoch auch hier keinerlei Hinweis darauf, daß eine vorteilhafte Wirkung erzielt werden kann, wenn mehr als 1 oder 2% von Stickstoff dem Prozeßplasma zugesetzt wird, um auf diese Art gewollt Filmschichteigenschaften, wie Adhäsion, Korrosionsbeständigkeit, mechanische Härte und $H^*_k$, zu verbessern, oder auch nur für den Zweck einen Parameter, wie z.B. Widerstandsfähigkeit und Magnetisierungsherabsetzung $(4\pi M_s)$ zu verstärken. Darüber hinaus werden die Elemente wie P, Si, Al, C, B, die in einer anderen Periode des Periodensystems der Elemente als Gd liegen, nicht erwähnt, da sie nicht magnetisch sind und Atomradien von etwa 0,091 bis 0,143 nm besitzen, wohingegen Gd einen Atomradius von etwa 0,179 nm aufweist. Die magnetischen Übergangsmetalle Fe, Co, Ni besitzen alle Atomradien von etwa 0,124 bis 0,126 nm, während Stickstoff einen Atomradius von 0,092 nm zeigt. Da der Atomradius von Stickstoff gleich der Hälfte von dem des Gadoliniumsist und damit näher in seiner Abmessung zu den Radien der Elemente steht, die zur amorphen Legierungszusammensetzung gemäß der Erfindung beitragen, läßt sich ersehen, daß Stickstoff kaum die gleiche Wirkung auf Gd, Fe besitzt wie auf Co, Fe, B, da es hinsichtlich seiner Struktur ziemlich zu Bor paßt. In oben angegebener Patentschrift wird die Anisotropie $K_u$ als abhängig von der Filmdicke der Niederschlagsrate und der Filmzusammensetzung aufgezeigt, jedoch wird nichts darüber ausgesagt, daß der Stickstoffgehalt die Größe $H^*_k$ beeinflussen könnte.

In der Veröffentlichung "Incorporation of Rare Gases in Sputtered Amorphous Metal Films", in "Journal of Vacuum Science and Technology", Band 14, Nr. 1, Seiten 152 bis 157 1977 wird auf Seite 156 festgestellt, daß "z.B. die große Argonkonzentration bei in einer $N_2$Ar-Mischung zerstäubtem Wolfram und bei in Argon zerstäubten Wolfram und Tantal aufgrund der Tatsache möglich ist, daß W und Ta im amorphen Zustand vorliegen. Obgleich die Autoren dieses Artikels nicht die Struktur der betreffenden Materialien angeben, ist es bekannt, daß diese Ubergangsmetalle leicht als amorphe Phasen zu stabilisieren sind, so daß sie deshalb leicht den Anteil an trägem Gas aufnehmen".

2

# 0 002 712

Das US-Patent 3 427 154 weist darauf hin, daß als Kriterium für das Vorliegen einer amorphen Legierung gilt, daß eine ausreichender Unterschied zwischen Komponentenatomradien vorliegen sollte, um eine Transformation infolge Diffusion oder Absonderung durch Kristallisation zu verhindern. Für Komponentenatome A und B mit den Radien $r_A$ und $r_B$ bestimmt sich der Abmessungsfaktor zu:

$$\frac{|r_B - r_A| \times 100\%}{1/2(r_A + r_B)}$$

Die Resultate sind wie folgt:

| Legierung | $R_B$(nm) | $R_A$(nm) | Prozentanteil |
|-----------|-----------|-----------|---------------|
| GdFe | 0,179 | 0,126 | 34% |
| GdN | 0,179 | 0,092 | 62% |
| FeN | 0,126 | 0,092 | 31% |
| FeB | 0,126 | 0,098 | 25% |
| BN | 0,098 | 0.092 | 6% |
| SiN | 0,132 | 0,092 | 36% |

Ganz offensichtlich unterscheidet sich Gd sehr viel mehr in seiner Abmessung von Fe und N als es für B und Si der Fall ist, so daß aufgrund oben gezeigter Untershiede auch nicht der Versuch eintreten kann, anzunehmen, daß die Elemente B, C, P, Si in bezug auf Abmessung oder Magneteigenschaften eng miteinander verwandt sein könnten.

Demgegenüber will die Erfindung insofern Abhilfe schaffen, als ein amorpher Metallegierungsfilm bereit gestellt werden soll, dem auf einfache Weise wesentlich bessere mechanische, magnetische oder elektrische Eigenschaften verliehen werden können.

Die Erfindung, wie sie in den Ansprüchen gekennzeichnet ist, löst die Aufgabe dadurch, daß im eingangs genannten Metallglas der Stickstoffanteil größer als 1 Atom-Prozent ist. Bei einem Stickstoffanteil von 14 bis 26 Atom-Prozent ergibt sich der Vorteil einer äußerst guten Adhäsionskraft, die einer Schäl- und Abhebeprüfung eines derartigen Metallglasfilms vom Substrat einen denkbar großen Widerstand entgegensetzt. Liegt der Stickstoffanteil im Metallglas im Bereich von 20 Atom-Prozen, dan erhöht sich die Härte des Films um 1° in der Mohsschen Härteskala gegenüber einer vergleichbaren Zusammensetzung eines Films jedoch ohne Stickstoffanteil. Um hohe magnetothermische Stabilität bis ungefähr 400°C zu erhalten, genügt es, wenn der Stickstoffanteil im amorphen Metallglasfilm etwa 9 Atom-Prozent beträgt; während sich ausgezeichnete Korrosionsbeständigkeit bereits dann einstellt, wenn zumindest etwa 10 Atom-Prozent Chrom oder Stickstoff in diesem Metallglasfilm vorliegt. Es hat sich fernerhin gezeigt, daß schon bei einem Stickstoffanteil von mehr als 1 Atom-Prozent eine im wesentlichen senkrecht ausgerichtete magnetische Anisotropie im Metallglas-film vorherrscht.

Durch Ändern des Stickstoffanteils in den Prozeßgasen beim Niederschlagen eines erfindungsgemäß auszubildenen Metallglasfilms läßt sich außerdem in einfacher Weise ein Laminat bereitstellen, dessen Schichtungen abwechselnd je nach einegestelltem Stickstoffanteil hohe und niedrige Magnetisierungswerte aufweisen, wenn berücksichtigt wird, daß bei Stickstoffanteilen oberhalb von 26 Atom-Prozent im Metallglasfilm praktisch keine Magnetisierung mehr vorliegt.

Im folgenden wird die Erfindung in einer Ausführungsbeispielsbeschreibung anhand unten aufgeführter Zeichnungen näher erlätert.

Es zeigen:

Fig. 1 eine graphische Darstellung, bei der die Feldstärke des senkrechten Anisotropiefeldes in Abhängigkeit vom Stickstoffanteil im Plasma aufgetragen ist,

Fig. 2 eine graphiche Darstellung, bei der der Atom-Prozent-Anteil an Stickstoff in Abhängigkeit vom Volumanteil des Stickstoffs im Plasma aufgetragen ist,

Fig. 3 eine graphische Darstellung, bei der der spezifische elektrische Widerstand in Abhängigkeit vom Volumanteil des Stickstoffs im Plasma aufgetragen ist,

Fig. 4 eine graphische Darstellung, bei der die Magnetisierung als Funktion vom Volumanteil des Stickstoffs im Plasma aufgetragen ist.

Die Übergangsmetallegierungen mit glasbildenden Elementen führen bei Zerstäuben in einer Stickstoffatmosphäre zu amorphen Filmen, die ausgezeichnete Adhäsionseigenschaften hinsichtlich der jeweiligen Substrate und ausgezeichnete mechanische Härteeigenschaften besitzen. Derartige Filme sind demnach besonders für Produkte, die sich laminierter Filme bedienen, geeignet. Derartige laminierte Filme enthalten in der Regel Alternierende Schichten, wobei Schichten mit starken und schwachen magnetischen Eigenschaften miteinander abwechseln können. Filme, die aus magnetischen Legierungen unter Ausschluß von Stickstoff zusammengesetzt sind, werden wegen ihrer starken magnetischen Charackteristiken verwendet, wohingegen stickstoffreiche Legierungen, die andererseits die gleiche chemische Zusammensetzung aufweisen, wegen ihrer reduzierten magnetischen Aktivität

3

oder gar ihrer magnetischen Inaktivität, ihrer erhöhten elektrischen Empfindlichkeit, stärkeren Adhäsionskräften und größeren mechanischen Härte Anwendung finden können. Derartige laminierte Filme eignen sich für die Verwendung in Produkten, wie Magnetaufzeichnungsköpfe mit geringem Barkhausen-Rauschen und niedrigerer Koerzitivkraft, die unter Anwenden vieler Laminationsschichten, z.B. 25 Schichten, gefertigt werden. Sie können außerdem mechanische und chemische Schutzmasken für Dünnfilmbaueinheiten liefern und sind brauchbar als Überzugsmaterialien für chirurgische Instrumente und Rasierklingen.

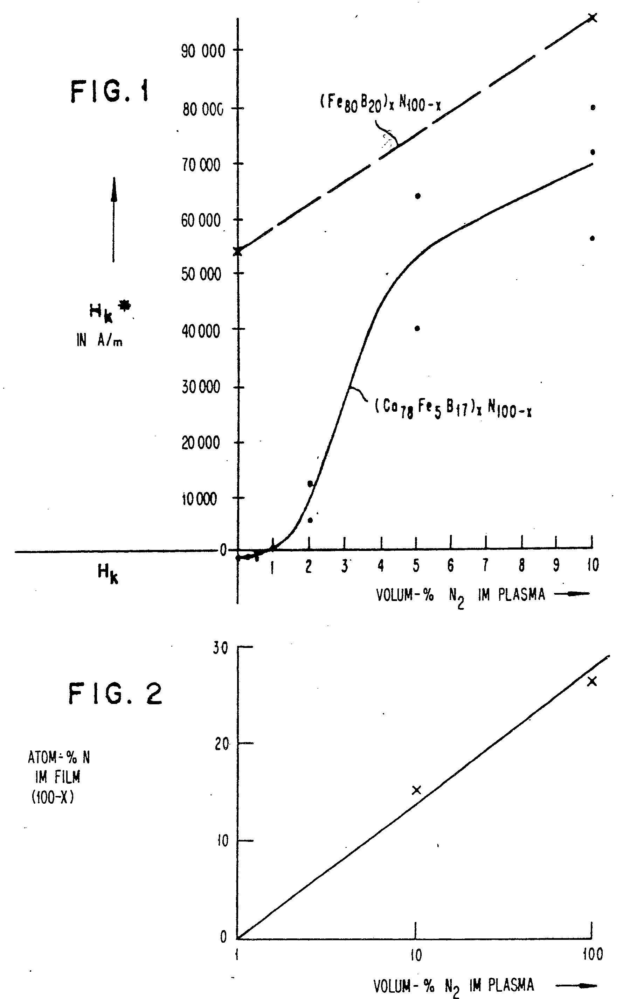

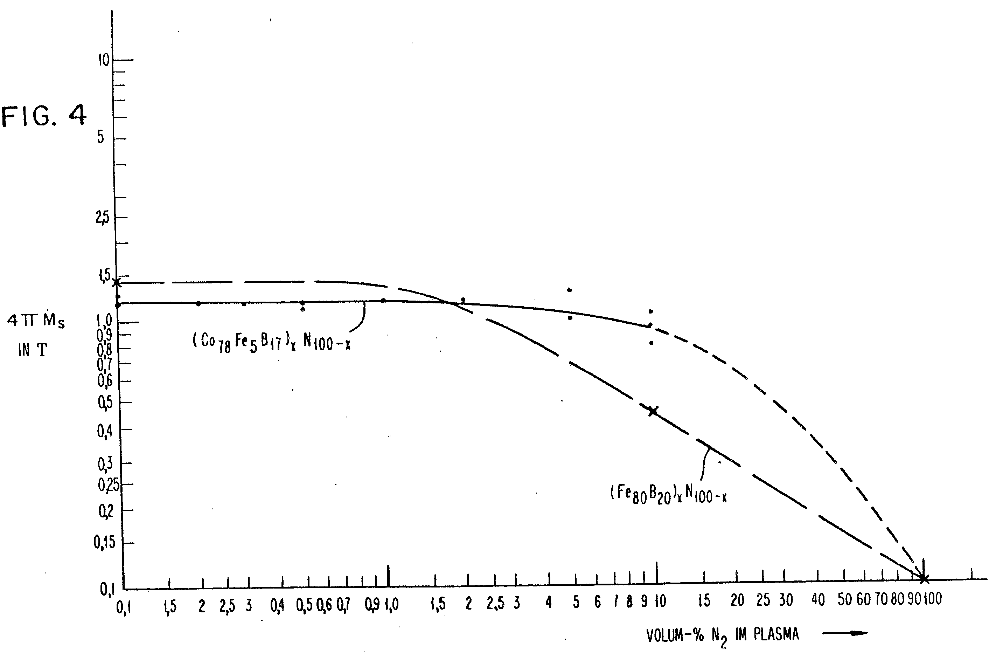

Eine für den Zerstäubungsprozeß vorgesehene Aufprallfläche kann aus einer Legierung mit einem oder mehreren Übergangsmetallen wie Cr, Fe, Co, Ni plus einem oder mehreren der Elemente Wie B, Si, C, P, Al, bestehen. Der Vol.-%-Satz an Stickstoff in der Zerstäubungskammer bestimmt dabei die verschiedenen Materialeigenschaften, wie sie den graphischen Darstellungen nach Fig. 1, 3, 4 und auch den Beispielen I bis II zugrunde liegen. Diese Filme enthalten mehr als etwa 1 Atom-% Stickstoff, wobei 2 Vol.-% von Stickstoff im Zerstäubungsplasma zugrunde liegt. Für gewisse Werte an Vol.-% Stickstoff im Plasma ändern sich die Werte für $H*_k$, den spezifischen elektrischen Widerstand und die Magnetisierung ganz erheblich. So beginnen sich z.B. die Werte bei nachstehend angegebenen Stickstoffgehalten, wie folgt, zu ändern: Oberhalb etwa 1 Vol.-% für $H*_k$ in Fig. 1, zwischen 3 bis 6 Vol.-% für den spezifischen elektrischen Widerstand in Fig. 2 und bei etwa 10% für die Magnetisierung in Fig. 4, obgleich für Vol.-% bei etwa 1% in allen drei Kurven nur eine sehr geringfügige Änderung ersichtlich ist.

Effektives Anisotropiefeld $H*_k$

In Fig. 1 sind zwei Kurven ersichtlich, die beide im wesentlichen die Änderung im effektiven, senkrecht gerichteten Anisotropiefeld $H*_k$ in Richtung der Normalen der Dünnfilmebene als Funktion vom Vol.-Prozentsatz an Stickstoff im Plasma darstellen. Zusätzlich sind unterhalb des Koordinatenursprungs die in Schichtebene gerichteten Anisotropiefeldwerte $H*_k$ für sehr geringe Prozentanteile Stickstoff, allerdings nur für die untere Kurve aufgetragen. Die untere Kurve zeigt einige Punkte für eine Co-, Fe-, B-, N-Legierung. Die Kurve steigt rasch bei 1 bis 2 Vol.-%, entsprechend etwa 1 Atom-% Stickstoff im Film an, um dann oberhalb etwa 5 Vol.-% Stickstoff weniger stark zuzunehmen, obgleich die Werter für $H*_k$ weiterhin bis zu 10 Vol.-% Stickstoff anwachsen. Bis zu 1 Vol.-% Stickstoff ist die Anisotropierichtung in Dünnfilmebene ausgerichtet, stellt sich jedoch positiv oder senkrecht zur Dünnfilmebene oberhalb von etwa 1 Vol.-% Stickstoff ein. Als zweite Kurve ist eine gestrichelt liniierte Kurve zwischen 0 bis 10 Vol.-% Stickstoff für eine Fe-B-N-Legierung aufgetragen, die in ihrem oberen Bereich zur ersten Kurve parallel verläuft, jedoch wesentlich höhere Werte für $H*_k$ im Gesamtbereich aufweist. Aus den unten aufgeführten Beispielen XVII, XVIII, XIX und XXII läßt sich ersehen, daß sich der Wert für $H*_k$ bei einem Vol.-Anteil von 100% Stickstoff in der Zerstäubungsatmosphäre auf Null reduziert, so daß also an diesem Punkt die Magneteigenschaften des Materials zerstört sind, wie es sich aus der graphischen Darstellung nach Fig. 4 ergibt und weiter unten bestätigen läßt. Die speziell verwendeten Legierungen sind mit ihrem Atomprozent-Anteil Stickstoff in Werten von 100-x angegeben, wobei der Atomprozent-Anteil der jeweils anderen Elemente in der Legierung gleich x ist.

Stickstoffanteil im Film

Fig. 2 zeigt eine Kurve, deren Ordinate dem Atom-%-Anteil Stickstoff im Film entspricht und auf deren logarithmisch eingeteilte Abszisse der Vol.-Prozentsatz Stickstoff im Plasma aufgetragen ist. Es ist offensichtlich, daß unbeachtlich der wenigen zur Verfügung stehenden Daten der Atom-Prozentsatz Stickstoff im Film eine lineare Funktion mit dem Logarithmus des Vol.-%-Satzes an Stickstoff im Plasma darstellt. So ist die Erhöhungsrate im Stickstoffgehalt im Film in Abhängigkeit von dem Stickstoffanteil im Prozeßgas weit geringer als linear. Im Film liegen etwa 14 Atom-% Stickstoff für 10 Vol.-% Stickstoff im Plasma vor und es ergeben sich etwa 26 Atom-% Stickstoff im Film für 100 Vol.-% Stickstoff im Plasma bei Zerstäubung.

Spezifischer elektrischer Widerstand

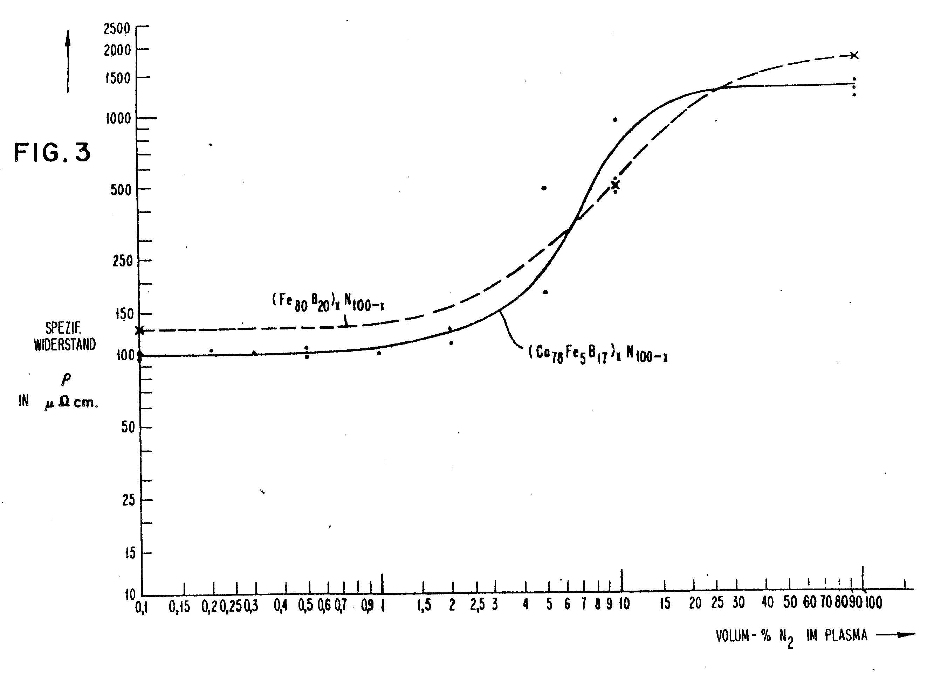

Fig. 3 zeigt, daß die Zugabe von Stickstoff sowohl in Fe-B-und Co-Fe-B-Legierungen zu einer Erhöhung des spezifischen elektrischen Widerstands fürt und etwa 200 $\mu\Omega$ cm erreicht wird, wobei sich eine große Anstiegsrate bei etwa 3 bis 6 Vol.-% Stickstoff im Plasma (entsprechend etwa 5 bis 7 Atom-% Stickstoff im Film) einstellt, das Anwachsen der Kurve jedoch bei etwa 1 Vol.-% Stickstoff beginnt und die Abflachung bei etwa 10 Vol.-% Stickstoff einsetof.

Magnetisierung

Fig. 4 zeigt, daß die Magnetisierung $4\pi M_s$ als Funktion des Vol.-Prozentanteils Stickstoffs absinkt, wobei der Absinkvorgang bei etwa 1 bis 4% Stickstoffanteil im Prozeßgas geginnt und deutlich sichtbar bei 10% Stickstoffanteil in Erscheinung tritt. Bei einem Anteil von etwa 10% Stickstoff im Prozeßgas ergibt sich für die Magnetisierung Null, so daß an diesem Punkt der Stickstoffgehalt im Film die betreffende Legierung magnetisch inaktiv macht, so daß dank dieser Eigenschaften es nunmehr möglich ist, ein Laminat, abwechselnd bestehend aus magnetischen und nichtmagnetischen Schichten, vorteilhafterweise sehr einfach herzustellen.

Adhäsion

Die erfindungsgemäß hergestellten Film sind auf ihre Adhäsionskräfte bezüglich eines SiO$_2$-Substrates oder oxidierten Siliciums, nämlich 0,5 $\mu$m SiO$_2$ auf Si geprüft worden. In einem Schäl- und Abziehtest ist ein metallischer Spulenkopf mit etwa 12,5 mm Durchmesser mit Hilfe eines Epoxids auf einen Film, bestehend aus einer Legierung (Fe$_{80}$B$_{20}$)$_x$N$_{10-x}$ aufgeklebt, wobei die Legierung auf ein Substrat in einer Atmosphäre von 100 Vol.-% Stickstoff aufgestäubt worden ist. Bei einem Versuch, den Spulenkopf und das Substrat auseinanderzuziehen, ist das Substrat gebrochen, doch der Film selbst dann noch nicht vom Spulenkopf freigegeben worden. Hierbei liegt der Atomanteil von Stickstoff im Film bei etwa 26%.

Es ist fernerhin ein Schäl- und Abziehtest unter Verwendung von durchsichtigem, selbstklebendem Band angewendet worden, das auf Co-Fe-B-N- und Fe-B-N-Filme mit 10 und 100 Vol.-% Stickstoff bei Herstellung im Plasma oder bei einem Gehalt von 14 bzw. 26 Atom-% Stickstoff im Film aufgebracht ist. Mit Hilfe des selbstklebenden Bandes leißen sich die Filme in diesem Falle nicht ablösen; obgleich es hiermit ohne weiteres möglich ist, Filme, bestehend aus 80:20-NiFe, Aluminium, Fe-Co-B und Fe-B ohne Stickstoffanteile voneinander zu trennen. Dies zeigt, daß ein Zusatz von Stickstoff zu beiden Legierungsfilmen ganz erheblich zur Verstärkung der Adhäsionskräfte, zumindest bei SiO$_2$, beitragen kann. Die Adhäsionsdaten sind beim Testen einiger Muster anhand der Beispiele I bis XXII zusammengestellt.

Härte

Die Härte von Fe-Cr-B-Filmen ist größer als die von Fe-B; die ihrerseits normalerweise größer ist als die von Co-Fe-B, bei der ein Mohsscher Skalenwert zwischen 6 und 7 oder Knoop-Härtewerte zwischen 560 und 710 vorliegen. Wird ein großer Prozentanteil an Stickstoff hinzugefügt, dann liegt die Härte von Co-Fe-B-N zwischen etwa 7 und 8 in der Mohsschen Skala oder beträgt zwischen 710 und 1250 in der Knoop-Härteskala, so daß also eine ganz erhebliche Zunahme in der Härte zu verzeichnen ist. Fe-Cr-B-N ist härter als Fe-B-N; das seinerseits härter ist als Co-Fe-B-N. Fe-Cr-B-N weist eine Härte von nahezu acht in der Mohsschen Skala oder von 1250 in der Knoopschen Härteskala auf. Diese Werte werden grob bei Ritzprüfung ermittelt. Z.B. besitzt Stahl eine Härte in der Mohsschen Skala von 6 oder 650 in der Knoopschen Härteskala; Co-Fe-B ritzt jedoch Stahl. In gleicher Weise ritzt Co-Fe-B-N Silicium oder Granat, wobei Quarz oder Si einen Härtewert in der Mobsschen Skala von 7 aufweisen. Ganz allgemein läßt sich demnach sagen, daß die Härte sich um 1° in der Mohsschen Skala erhöhen läßt, wenn bei Filmherstellung gemäß der Erfindung 100 Vol.-% Stickstoff in der Zerstäubungsatmosphäre vorgesehen werden; was etwa 26 Atom-% Stickstoff im fertiggestellten Film entspricht.

Magnetothermische Stabilität

Es hat sich herausgestellt, daß die magnetothermische Stabilität oberhalb eines Stickstoffanteils von etwa 5 Vol.-% in der Zerstäubungsatmosphäre oder etwa 9 Atom-%-Anteil im Film ansteigt. Jedoch zeicht sich bei den Filmen im wesentlichen keinerlei Änderung beim Vergüten, da bis zu 400°C Strukturund Magneteigenschaften unverändert bleiben. Die Materialien sind unter und ohne Einfluß eines äußeren Magnetfeldes von etwa 6 · 10$^{-5}$ bis 8 · 10$^{-5}$ Vs/cm$^2$ für etwa eine Stunde bei 400°C vergütet. Nicht die geringsten Änderungen lassen sich aus Versuch 29, Beispiel XII (5% Stickstoff) und Versuch 25, Beispiel XV (10% Stickstoff) ersehen.

Korrosionsbeständigkeit

Wenn die erfindungsgemäßen Übergangsmetall-Glas-Filme einen größeren Anteil als etwa 10 Atom-% Cr enthalten, dann zeigen sich ausgezeichnete Korrosionsbeständigkeitseigenschaften. Oberhalb von etwa 10 Atom-% Stickstoff lassen sich in gleicher Weise bei diesen Legierungen ausgezeichnete Korrosionsbeständigkeits-Eigenschaften beobachten. Sowie der Stickstoffanteil erhöht wird, wächst auch die Korrosionsbeständigkeit an, wie es sich aus einem entsprechenden Test mit abnehmender Ätzrate unter Verwendung einer Eisenchlorid-Säurelösung ergibt.

Zerstäubungseinrichtung

Die verwendete Zerstäubungseinrichtung entspricht in ihrer Anordnung einer anderwärts bereits vorgeschlagenen Zerstäubungseinrichtung. Vorliegende Einrichtung wird unter ähnlichen Bedingungen betrieben, wobei lediglich Unterschiede in bezug auf Spannungen, Druck (negative Ionen nicht nicht beteiligt) und im Gasgehalt vorliegen.

Alternative Herstellungsausrüstung

Das Niederschlagen derartiger Filme läßt sich auch mit anderen Geräten durchführen, z.B. Ionen-Plattierungssystemen, die Stickstoff in der Plattierungskammer anwenden. Die hierzu erforderlichen Materialquellen lassen sich mit ähnlicher Zusammensetzung wie die der Zerstäubungsaufprallflächen verwenden. Alternativ lassen sich auch reaktive Sekundär-Ionen-strahl-Niederschlagsverfahren zur Bereitstellung der Filme verwenden.

### Beispiel I

Aufprallkörper $Co_{78}Fe_5B_{17}$
Versuchs-Nr.: 36

| | Vorzerstäubung | Zerstäubung |
|---|---|---|
| Prozent $N_2$: Prozent Ar | 0:100 | 0:100 |
| HF-Vorlaufleistung in W | 90/10 | 90/5 |
| HF-Rücklaufleistung in W | 5/1 | 5/0 |
| Kathodengleichspannung in V | 1000 | 1000 |
| Gleichvorspannung in V | 50 | 50 |
| Kammeranfangsdruck in bar | 0,67 | 0,67 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 594 |
| Quadratflächenwiderstand in $\Omega$ | 2,01 |
| Spezifischer Widerstand in $\mu\Omega$ cm | 106 |
| Magnetisierung ($4\pi M_s$) | 11,3 |
| $H_k$ in A/m | −1110 |

### Beispiel II

Aufprallkörper $Co_{78}Fe_5B_{17}$
Versuchs-Nr.: 35

| | Vorzerstäubung | Zerstäubung |
|---|---|---|
| Prozent $N_2$: Prozent Ar | 0,1:99,9 | 0,1:99,9 |
| HF-Vorlaufleistung in W | 90 | 90 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 5,1 | 5,1 |
| Kammerdruck in mbar | 27 | 27 |
| Kathodendurchmesser in cm | 11,43 | 11,43 |
| Zeitdauer in min | 45 | 45 |
| Temperatur: | die kalten Wassers | |

| | |
|---|---|
| Filmdicke in nm | 364 |
| Quadratflächenwiderstand in $\Omega$ | — |
| Spezifischer Widerstand in $\mu\Omega$ cm | 98 |
| Magnetisierung ($4\pi M_s$) | 11,6 |
| $H_k$ in A/m | −1270 |

### Beispiel III

Aufprallkörper $Co_{78}Fe_5B_{17}$
Versuchs-Nr.: 37

| | Vorzerstäubung | Zerstäubung |
|---|---|---|
| Prozent $N_2$: Prozent Ar | 0,1:99,9 | 0,1:99,9 |
| HF-Vorlaufleistung in W | 90/4 | 90/3 |
| HF-Rücklaufleistung in W | 6/0 | 6/0 |
| Kathodengleichspannung in V | 1000 | 1000 |
| Gleichvorspannung in V | 50 | 50 |
| Kammeranfangsdruck in bar | 4,3 | 4,3 |
| Kammerdruck in mbar | 27 | 27 |
| Kathodendurchmesser in cm | 11,43 | 11,43 |
| Zeitdauer in min | 30 | 60 |
| Temperatur: | die kalten Wassers | |

| | |
|---|---|
| Filmdicke in nm | 485 |
| Quadratflächenwiderstand in $\Omega$ | 1,84 |
| Spezifischer Widerstand in $\mu\Omega$ cm | 98 |
| Magnetisierung ($4\pi M_s$) | 12,3 |
| $H_k$ in A/m | −1190 |

## Beispiel IV

Aufprallkörper $Co_{78}Fe_5B_{17}$
Versuchs-Nr.: 41

| | Vorzerstäubung | Zerstäubung |
|---|---|---|
| Prozent $N_2$: Prozent Ar | 0,1:99,9 | 0,1:99,9 |
| HF-Vorlaufleistung in W | 90/3 | 90/3 |
| HF-Rücklaufleistung in W | 2,5:0 | 2,5:0 |
| Kathodengleichspannung in V | 1000 | 1000 |
| Gleichvorspannung in V | 50 | 50 |
| Kammeranfangsdruck in bar | 0,67 | 0,67 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 594 |
| Quadratflächenwiderstand in $\Omega$ | 1,72 |
| Spezifischer Widerstand in $\mu\Omega$ cm | 102 |
| Magnetisierung $(4\pi M_s)$ | 11,4 |
| $H_k$ in A/m | −1110 |

## Beispiel V

Aufprallkörper $Co_{78}Fe_5B_{17}$
Versuchs-Nr.: 38

| | Vorzerstäubung | Zerstäubung |
|---|---|---|
| Prozent $N_2$: Prozent Ar | 0,2:99,8 | 0,2:99,8 |
| HF-Vorlaufleistung in W | 90/3 | 90/3 |
| HF-Rücklaufleistung in W | 0/0 | 0/0 |
| Kathodengleichspannung in V | 1000 | 1000 |
| Gleichvorspannung in V | 50 | 50 |
| Kammeranfangsdruck in bar | 2 | 2 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 509 |
| Quadratflächenwiderstand in $\Omega$ | 1,81 |
| Spezifischer Widerstand in $\mu\Omega$ cm | 102 |
| Magnetisierung $(4\pi M_s)$ | 11,8 |
| $H_k$ in A/m | −954 |

## Beispiel VI

Aufprallkörper $Co_{78}Fe_5B_{17}$
Versuchs-Nr.: 39

| | Vorzerstäubung | Zerstäubung |
|---|---|---|
| Prozent $N_2$: Prozent Ar | 0,3:99,7 | 0,3:99,7 |
| HF-Vorlaufleistung in W | 90/3 | 90/3 |
| HF-Rücklaufleistung in W | 5/0 | 5/0 |
| Kathodengleichspannung in V | 1000 | 1000 |
| Gleichvorspannung in V | 50 | 50 |
| Kammeranfangsdruck in bar | 0,6 | 0,6 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 534 |
| Quadratflächenwiderstand in $\Omega$ | 1,67 |
| Spezifischer Widerstand in $\mu\Omega$ cm | 101 |
| Magnetisierung $(4\pi M_s)$ | 11,3 |
| $H_k$ in A/m | −1190 |

## Beispiel VII

Aufprallkörper $Co_{78}Fe_5B_{17}$
Versuchs-Nr.: 40

|  | Vorzerstäubung | Zerstäubung |
|---|---|---|
| Prozent $N_2$: Prozent Ar | 0,5:99,5 | 0,5:99,5 |
| HF-Vorlaufleistung in W | 90/3 | 90/3 |
| HF-Rücklaufleistung in W | 7/0 | 7/0 |
| Kathodengleichspannung in V | 1000 | 1000 |
| Gleichvorspannung in V | 50 | 50 |
| Kammeranfangsdruck in bar | 2,7 | 2,7 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 534 |
| Quadratflächenwiderstand in $\Omega$ | 1,78 |
| Spezifischer Widerstand in $\mu\Omega$ cm | 105 |
| Magnetisierung $(4\pi M_s)$ | 11,5 |
| $H_k$ in A/m | −1190 |

## Beispiel VIII

Aufprallkörper $Co_{78}Fe_5B_{17}$
Versuchs-Nr.: 43

|  | Vorzerstäubung | Zerstäubung |
|---|---|---|
| Prozent $N_2$: Prozent Ar | 0,5:99,5 | 0,5:99,5 |
| HF-Vorlaufleistung in W | 90/3 | 90/3 |
| HF-Rücklaufleistung in W | 5/1 | 5/1 |
| Kathodengleichspannung in V | 1000 | 1000 |
| Gleichvorspannung in V | 50 | 50 |
| Kammeranfangsdruck in bar | 2,7 | 2,7 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 485 |
| Quadratflächenwiderstand in $\Omega$ | 1,99 |
| Spezifischer Widerstand in $\mu\Omega$ cm | 96 |
| Magnetisierung $(4\pi M_s)$ | 11,1 |
| $H_k$ in A/m | −716 |

## Beispiel IX

Aufprallkörper $Co_{78}Fe_5B_{17}$
Versuchs-Nr.: 42

|  | Vorzerstäubung | Zerstäubung |
|---|---|---|
| Prozent $N_2$: Prozent Ar | 1:99 | 1:99 |
| HF-Vorlaufleistung in W | 90/2 | 90/2 |
| HF-Rücklaufleistung in W | 10/0 | 10/0 |
| Kathodengleichspannung in V | 1000 | 1000 |
| Gleichvorspannung in V | 50 | 50 |
| Kammeranfangsdruck in bar | 1,3 | 1,3 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 485 |
| Quadratflächenwiderstand in $\Omega$ | 2,17 |
| Spezifischer Widerstand in $\mu\Omega$ cm | 101 |
| Magnetisierung $(4\pi M_s)$ | 11,8 |
| $H_k$ in A/m | −398 |

# 0 002 712

## Beispiel X

Aufprallkörper $Co_{78}Fe_5B_{17}$
Versuchs-Nr.: 28

|  | Vorzerstäubung | Zerstäubung |
|---|---|---|
| Prozent $N_2$: Prozent Ar | 2:98 | 2:98 |
| HF-Vorlaufleistung in W | 70 | 70 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 3,2 | 3,2 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| Filmdicke in nm | 303 |
|---|---|
| Quadratflächenwiderstand in $\Omega$ | 4,4 |
| Spezifischer Widerstand in $\mu\Omega$ cm | 128 |
| Magnetisierung ($4\pi M_s$) | ·11,5 |
| $H_k$ in A/m | +11920 |

## Beispiel XI

Aufprallkörper $Co_{78}Fe_5B_{17}$
Versuchs-Nr.: 44

|  | Vorzerstäubung | Zerstäubung. |
|---|---|---|
| Prozent $N_2$: Prozent Ar | 2:98 | 2:98 |
| HF-Vorlaufleistung in W | 90/3 | 90/3 |
| HF-Rücklaufleistung in W | 6/1 | 3/0 |
| Kathodengleichspannung in V | 1000 | 1000 |
| Gleichvorspannung in V | 50 | 50 |
| Kammeranfangsdruck in bar | 5,1 | 5,1 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| Filmdicke in nm | 424 |
|---|---|
| Quadratflächenwiderstand in $\Omega$ | 2,50 |
| Spezifischer Widerstand in $\mu\Omega$ cm | 110 |
| Magnetisierung ($4\pi M_s$) | 11,7 |
| $H_k$ in A/m | +5560 |

## Beispiel XII

Aufprallkörper $Co_{78}Fe_5B_{17}$
Versuchs-Nr.: 29

|  | Vorzerstäubung | Zerstäubung |
|---|---|---|
| Prozent $N_2$: Prozent Ar | 5:98 | 5:98 |
| HF-Vorlaufleistung in W | 70 | 70 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 4,3 | 4,3 |
| Kammerdruck in mbar | 20 | 20 |
| Kathodendurchmesser in cm | 11,43 | 11,43 |
| Zeitdauer in min | 60 | 60 |
| Temperatur: | die kalten Wassers | |

| Filmdicke in nm | 364 |
|---|---|
| Quadratflächenwiderstand in $\Omega$ | 14,96 |
| Spezifischer Widerstand in $\mu\Omega$ cm | 481 |
| Magnetisierung ($4\pi M_s$) | 10 |
| $H_k$ in A/m | +63600 |

# 0 002 712

## Beispiel XIII

Aufprallkörper $Co_{78}Fe_5B_{17}$
Versuchs-Nr.: 34

|  | Vorzerstäubung | Zerstäubung |
|---|---|---|
| Prozent $N_2$: Prozent Ar | 5:98 | 5:98 |
| HF-Vorlaufleistung in W | 95 | 95 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 2,3 | 2,3 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| Filmdicke in nm | 388 |
|---|---|
| Quadratflächenwiderstand in $\Omega$ | — |
| Spezifischer Widerstand in $\mu\Omega$ cm | 178 |
| Magnetisierung ($4\pi M_s$) | 12,5 |
| $H_k$ in A/m | +39700 |

## Beispiel XIV

Aufprallkörper $Co_{78}Fe_5B_{17}$
Versuchs-Nr.: 22

|  | Vorzerstäubung | Zerstäubung |
|---|---|---|
| Prozent $N_2$: Prozent Ar | 10:90 | 10:90 |
| HF-Vorlaufleistung in W | 70 | 65 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 4,9 | 4,9 |
| Kammerdruck in mbar | 27 | 27 |
| Kathodendurchmesser in cm | 10,16 | 10,16 |
| Zeitdauer in min | 30 | 60 |
| Temperatur: | die kalten Wassers | |

| Filmdicke in nm | 469 |
|---|---|
| Quadratflächenwiderstand in $\Omega$ | 12,85 |
| Spezifischer Widerstand in $\mu\Omega$ cm | 467 |
| Magnetisierung ($4\pi M_s$) | 9,4 |
| $H_k$ in A/m | +55600 |

## Beispiel XV

Aufprallkörper $Co_{78}Fe_5B_{17}$
Versuchs-Nr.: 25

|  | Vorzerstäubung | Zerstäubung |
|---|---|---|
| Prozent $N_2$: Prozent Ar | 10:90 | 10:90 |
| HF-Vorlaufleistung in W | 200 | 200 |
| HF-Rücklaufleistung in W | 0 | 0 |
| Kathodengleichspannung in V | 2000 | 2000 |
| Gleichvorspannung in V | 50 | 50 |
| Kammeranfangsdruck in bar | 3.2 | 3.2 |
| Kammerdruk in mbar | 27 | 27 |
| Kathodendurchmesser in cm | 10,16 | 10,16 |
| Zeitdauer in min | 30 | 120 |
| Temperatur: | die kalten Wassers | |

| Filmdicke in nm | 3200 |
|---|---|
| Quadratflächenwiderstand in $\Omega$ | 1,56 |
| Spezifischer Widerstand in $\mu\Omega$ cm | 512 |
| Magnetisierung ($4\pi M_s$) | 10,4 |
| $H_k$ in A/m | +79580 |

10

# 0 002 712

## Beispiel XVI

Aufprallkörper $Co_{78}Fe_5B_{17}$
Versuchs-Nr.: 33

|  | Vorzerstäubung | Zerstäubung |
|---|---|---|
| Prozent $N_2$: Prozent Ar | 10:90 | 10:90 |
| HF-Vorlaufleistung in W | 90 | 90 |
| HF-Rücklaufleistung in W | 0 | 0 |
| Kathodengleichspannung in V | 1000 | 1000 |
| Gleichvorspannung in V | 50 | 50 |
| Kammerfangsdruck in bar | 1,1 | 1,1 |
| Kammerdruck in mbar | 27 | 27 |
| Kathodendurchmesser in cm | 11,43 | 11,43 |
| Zeitdauer in min | 60 | 60 |
| Temperatur: | die kalten Wassers | |

| | |
|---|---|
| Filmdicke in nm | 485 |
| Quadratflächenwiderstand in $\Omega$ | — |
| Spezifischer Widerstand in $\mu\Omega$ cm | 976 |
| Magnetisierung ($4\pi M_s$) | 7,9 |
| $H_k$ in A/m | +71600 |

## Beispiel XVII

Aufprallkörper $Co_{78}Fe_5B_{17}$
Versuchs-Nr.: 21

|  | Vorzerstäubung | Zerstäubung |
|---|---|---|
| Prozent $N_2$: Prozent Ar | 100:0 | 100:0 |
| HF-Vorlaufleistung in W | 85 | 85 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 1,6 | 1,6 |
| Kammerdruck in mbar | 27 | 27 |
| Kathodendurchmesser in cm | 10,16 | 10,16 |
| Zeitdauer in min | 30 | 60 |
| Temperatur: | die kalten Wassers | |

| | |
|---|---|
| Filmdicke in nm | 2620 |
| Quadratflächenwiderstand in $\Omega$ | 11,05 |
| Spezifischer Widerstand in $\mu\Omega$ cm | 1362 |
| Magnetisierung ($4\pi M_s$) | — |
| $H_k$ in A/m | 0 |

## Beispiel XVIII

Aufprallkörper $Co_{78}Fe_5B_{17}$
Versuchs-Nr.: 23

|  | Vorzerstäubung | Zerstäubung |
|---|---|---|
| Prozent $N_2$: Prozent Ar | 100:0 | 100:0 |
| HF-Vorlaufleistung in W | 120 | 120 |
| HF-Rücklaufleistung in W | 0 | 0 |
| Kathodengleichspannung in V | 1000 | 1000 |
| Gleichvorspannung in V | 100 | 100 |
| Kammeranfangsdruck in bar | 5,9 | 5,9 |
| Kammerdruck in mbar | 27 | 27 |
| Kathodendurchmesser in cm | 10,16 | 10,16 |
| Zeitdauer in min | 30 | 60 |
| Temperatur: | die kalten Wassers | |

| | |
|---|---|
| Filmdicke in nm | 121 |
| Quadratflächenwiderstand in $\Omega$ | 16 |
| Spezifischer Widerstand in $\mu\Omega$ cm | 1295 |
| Magnetisierung ($4\pi M_s$) | — |
| $H_k$ in A/m | 0 |

11

## 0 002 712

### Beispiel XIX

Aufprallkörper $Co_{78}Fe_5B_{17}$
Versuchs-Nr.: 26

|  | Vorzerstäubung | Zerstäubung |
|---|---|---|
| Prozent $N_2$: Prozent Ar | 100:0 | 100:0 |
| HF-Vorlaufleistung in W | 95 | 95 |
| HF-Rücklaufleistung in W | 0 | 0 |
| Kathodengleichspannung in V | 2000 | 2000 |
| Gleichvorspannung in V | 50 | 50 |
| Kammeranfangsdruck in bar | 2,4 | 2,4 |
| Kammerdruck in mbar | 27 | 27 |
| Kathodendurchmesser in cm | 10,16 | 10,16 |
| Zeitdauer in min | 30 | 120 |
| Temperatur: | die kalten Wassers | |

| | |
|---|---|
| Filmdicke in nm | 1697 |
| Quadratflächenwiderstand in $\Omega$ | 2,2 |
| Spezifischer Widerstand in $\mu\Omega$ cm | 1338 |
| Magnetisierung $(4\pi M_s)$ | — |
| $H_k$ in A/m | 0 |

### Beispiel XX

Aufprallkörper $Co_{78}Fe_5B_{17}$
Versuchs-Nr.: 14

|  | Vorzerstäubung | Zerstäubung |
|---|---|---|
| Prozent $N_2$: Prozent Ar | 0:100 | 0:100 |
| HF-Vorlaufleistung in W | 80 | 80 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 1,5 | 1,5 |
| Kammerdruck in mbar | 27 | 27 |
| Kathodendurchmesser in cm | 11,43 | 11,43 |
| Zeitdauer in min | 30 | 60 |
| Temperatur: | die kalten Wassers | |

| | |
|---|---|
| Filmdicke in nm | 339 |
| Quadratflächenwiderstand in $\Omega$ | 2,98 |
| Spezifischer Widerstand in $\mu\Omega$ cm | 128 |
| Magnetisierung $(4\pi M_s)$ | 14,1 |
| $H_k$ in A/m | +54100 |
| Hartestufe (Mohs) | 7 |

### Beispiel XXI

Aufprallkörper $Co_{78}Fe_5B_{17}$
Versuchs-Nr.: 16

|  | Vorzerstäubung | Zerstäubung |
|---|---|---|
| Prozent $N_2$: Prozent Ar | 10:90 | 10:90 |
| HF-Vorlaufleistung in W | 85 | 85 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 4,3 | 4,3 |
| Kammerdruck in mbar | 27 | 27 |
| Kathodendurchmesser in cm | 11,43 | 11,43 |
| Zeitdauer in min | 30 | 60 |
| Temperatur: | die kalten Wassers | |

| | |
|---|---|
| Filmdicke in nm | 546 |
| Quadratflächenwiderstand in $\Omega$ | 48,6 |
| Spezifischer Widerstand in $\mu\Omega$ cm | 502 |
| Magnetisierung $(4\pi M_s)$ | 4,4 |
| $H_k$ in A/m | +95400 |
| Hartestufe nach Mohs | 8 |

12

# 0 002 712

Beispiel XXII

Aufprallkörper $Co_{78}Fe_5B_{17}$
Versuchs-Nr.: 15

|  | Vorzerstäubung | Zerstäubung |
|---|---|---|
| Prozent $N_2$: Prozent Ar | 100:0 | 100:0 |
| HF-Vorlaufleistung in W | 85 | 85 |
| HF-Rücklaufleistung in W | 0 | 0 |
| Kathodengleichspannung in V | 1000 | 1000 |
| Gleichvorspannung in V | 50 | 50 |
| Kammeranfangsdruck in bar | 2,1 | 2,1 |
| Kammerdruck in mbar | 27 | 27 |
| Kathodendurchmesser in cm | 11,43 | 11,43 |
| Zeitdauer in min | 30 | 60 |
| Temperatur: | die kalten Wassers | |

|  |  |
|---|---|
| Filmdicke in nm | 252 |
| Quadratflächenwiderstand in $\Omega$ | 17,5 |
| Spezifischer Widerstand in $\mu\Omega$ cm | 1725 |
| Magnetisierung $(4\pi M_s)$ | 0 |
| $H_k$ in A/m | 0 |
| Härtestufe nach Mohs | 9 |

## Patentansprüche

1. Stickstoff enthaltender Metallglasfilm ausschließlich bestehend sowohl aus mindestens einem der Übergangsmetalle Cr, Fe, Co, Ni als auch aus mindestens einem der Metalloide B, Si, C, P oder dem Metall Al als jeweilige Bestandteile einer eutektischen binären oder ternären Legierung, dadurch gekennzeichnet, daß der Stickstoffanteil im Metallglas größer als 1 Atomprozent ist.

2. Metallglasfilm nach Anspruch 1, dadurch gekennzeichnet, daß zu seiner Herstellung mittels Kathodenzerstäubung zumindest 2 Vol.-Prozent Stickstoff im Prozeßplasma enthalten ist.

3. Metallglasfilm mindestens nach Anspruch 1, gekennzeichnet durch eine aus Co-Fe-B-N bestehende Legierung.

4. Metallglasfilm nach Anspruch 3, dadurch gekennzeichnet, daß die Legierung aus $(Co_{78}Fe_5B_{17})_xN_{100-x}$ besteht, wobei für 100-x zumindest 1% von x gilt.

5. Metallglasfilm nach Anspruch 1, und/oder 2, dadurch gekennzeichnet, daß die Legierung aus Fe-B-N zusammengesetzt ist.

6. Metallglasfilm nach Anspruch 5, dadurch gekennzeichnet, daß die Legierung aus $(Fe_{80}B_{20})_xN_{100-x}$ besteht, wo 100-x zumindest etwa 1% von x ist.

7. Metallglasfilm nach den Ansprüchen 1 bis 6, dadurch gekennzeichnet, daß der hierin enthaltene Stickstoffanteil zwischen 9 und 26 Atom-Prozent liegt.

## Claims

1. Nitrogen-containing metallic glass film, consisting exclusively of at least one of the transition metals Cr, Fe, Co, Ni, as well as of at least one of the metalloids B, Si, C, P, or metal Al as the respective components of a eutectic binary of ternary alloy, characterized in that the nitrogen portion in the metallic glass is greater than 1 atomic percent.

2. Metallic glass film as claimed in claim 1 characterized in that for its production by means of cathode sputtering at least 2 volume percent of nitrogen are contained in the process plasma.

3. Metallic glass film as claimed in at least claim 1, characterized by a eutectic alloy consisting of Co-Fe-B-N.

4. Metallic glass film as claimed in claim 3, characterized in that the eutectic alloy consists of $(Co_{78}Fe_5B_{17})_xN_{100-x}$, where 100-x is at least 1% of x.

5. Metallic glass film as claimed in claim 1, and/or 2, characterized in that the eutectic alloy is composed of Fe-B-N.

6. Metallic glass film as claimed in claim 5, characterized in that the eutectic alloy consists of $(Fe_{80}B_{20})_xN_{100-x}$, where 100-x is at least approximately 1% of x.

7. Metallic glass film as claimed in any one of claims 1 to 6, characterized in that the nitrogen portion contained therein is between 9 and 26 atomic percent.

## Revendications

1. Film vitro-métallique contenant de l'azote, exclusivement composé d'au moins un des métaux de transition Cr, Fe, Co, Ni et d'au moins un des métalloïdes B, Si, C, P ou du métal Al comme

13

**0 002 712**

composants respectifs d'un alliage binaire ou ternaire eutectique, caractérisé en ce que la teneur atomique en azote dans le film vitro-métallique est supérieure à un 1%.

2. Film vitro-métallique selon la revendication 1, caractérisé en ce que, pour sa production à l'aide de la pulvérisation cathodique, le plasma de traitement contient au moins 2% en volume d'azote.

3. Film vitro-métallique selon au moins la revendication 1, caractérisé par un alliage eutectique composé de Co-Fe-B-N.

4. Film vitro-métallique selon la revendication 3, caractérisé en ce que l'alliage eutectique est composé de $(Co_{78}Fe_5B_{17})_xN_{100-x}$, 100-x représentant au moins 1% de x.

5. Film vitro-métallique selon les revendications 1 et/ou 2, caractérisé en ce que l'alliage eutectique est composé de Fe-B-N.

6. Film vitro-métallique selon la revendication 5, caractérisé en ce que l'alliage eutectique est composé de $(Fe_{80}B_{20})_xN_{100-x}$, 100-x représentant au moins 1% de x.

7. Film vitro-métallique selon les revendications 1 à 6, caractérisé en ce que la teneur atomique en azote qu'il contient est comprise entre 9 et 25%.

14

0 002 712

FIG. 1

$H_k$ ⁂
IN A/m

$H_k$

$(Fe_{80}B_{20})_x N_{100-x}$

$(Co_{78}Fe_5B_{17})_x N_{100-x}$

VOLUM-% $N_2$ IM PLASMA

FIG. 2

ATOM-% N
IM FILM
(100-X)

VOLUM-% $N_2$ IM PLASMA

1

FIG.3

SPEZIF.
WIDERSTAND

$\rho$

IN $\mu \Omega$ cm.

$(Fe_{80}B_{20})_x N_{100-x}$

$(Co_{78}Fe_5B_{17})_x N_{100-x}$

VOLUM- % N$_2$ IM PLASMA

0 002 712

2

FIG. 4

$4\pi \dot{M}_s$ IN T

$(Co_{78}Fe_5B_{17})_x N_{100-x}$

$(Fe_{80}B_{20})_x N_{100-x}$

VOLUM-% $N_2$ IM PLASMA

0 002 712